# EUROPEAN PATENT SPECIFICATION

(11) **EP 0 577 108 B1**
(45) Date of publication and mention of the grant of the patent: **04.06.1997**
(21) Application number: 93110466.5
(22) Date of filing: 30.06.1993
(51) Int. Cl.: H01L 31/20, H01L 31/18, H01L 27/142

(54) **Method and apparatus for eliminating short circuit portions in semiconductor elements**
Verfahren und Vorrichtung zum Beheben von Kurzschlussbereichen in Halbleiterelementen
Méthode et dispositif d'élimination de régions de court-circuit dans des éléments semiconducteurs

(30) Priority: 01.07.1992 JP 197828/92
(43) Date of publication of application: 05.01.1994
(73) Proprietor: CANON KABUSHIKI KAISHA, Tokyo (JP)
(72) Inventor: Midorikawa, Takafumi, Ohta-ku, Tokyo 146 (JP); Murakami, Tsutomu, Ohta-ku, Tokyo 146 (JP); Mori, Takahiro, Ohta-ku, Tokyo 146 (JP); Ichinose, Hirofumi, Ohta-ku, Tokyo 146 (JP)
(74) Representative: Tiedtke, Harro, Dipl.-Ing.

(56) References cited:
- EP-A- 0 268 272
- EP-A- 0 500 071
- JOURNAL OF APPLIED PHYSICS. vol. 61, no. 4, 15 February 1987, NEW YORK US pages 1648 - 1649 M.MATSUMURA ET AL. 'Improvement of amorphous silicon solar cells by electrochemical treatments'
- PATENT ABSTRACTS OF JAPAN vol. 11, no. 119 (E-499)14 April 1987 & JP-A-61 265 874

## Description

The present invention relates to a fabrication method for a reliable semiconductor element. And more particularly, the invention relates to a method and apparatus for fabricating a reliable semiconductor element having high initial characteristics wherein a short or shunt occurring in the fabrication process is compensated.

### Related Background Art

Photoelectric conversion elements in the form of semiconductor devices for converting light into electrical energy have been utilized extensively as voltage sources for electronic instruments such as electronic calculators or wristwatches, and have become widely accepted as the practicable art for alternative electric power of so-called fossil fuel such as petroleum or coal.

Photovoltaic elements are based on the art of utilizing the diffusion potential arising in the pn junction of semiconductor, wherein light carriers consisting of electrons and positive holes are produced when the semiconductor such as silicon absorbs the light, with the light carriers being drifted by internal electric field caused by the diffusion potential at the pn junction, and drawn outside. The fabrication of photovoltaic elements is carried out with the process for use with the fabrication of semiconductor elements. Specifically, single crystal of silicon is fabricated with valence electrons controlled in p-type or n-type by a crystal growth method such as a CZ method, with the single crystal being sliced into silicon wafers having a thickness of 300 µm. Further, the pn junction is created by forming a different conduction type layer by appropriate means such as that for diffusing a valence electron control agent to obtain an opposite conduction type to that of the wafer.

By the way, the fabrication method for photovoltaic elements uses the crystal-type semiconductor fabrication process as above described, in which there is a problem that the production costs are higher than those of the existing power generating methods.

From such a reason, to put to practical use solar cells as the power source of photovoltaic element, the lower cost is an important technical subject, for which various examinations have been made to obtain inexpensive materials or materials of high conversion efficiency. Such solar cell materials may include tetrahedral type semiconductors such as silicon, silicon germanium and silicon carbide, and compound semiconductors of II-VI group such as CdS and Cu₂ or III-V group such as GaAs and GaAlAs. In particular, thin film solar cells-using amorphous type semiconductor have been expected because of their merits that semiconductors of larger area can be fabricated than single crystal, the film thickness of semiconductor can be made thin, and arbitrary substrate materials can be used for deposition.

As amorphous silicon type photovoltaic element (hereinafter referred to as a solar cell) typically has a structure that a substrate is provided with a lower electrode, on which semiconductor junctions of thin film consisting of a p-type semiconductor region, an i-type semiconductor region and an n-type semiconductor region are laminated, and further an upper electrode is provided thereon. Further, to increase the current collection efficiency, a grid electrode or a bus bar may be provided.

The amorphous silicon type photovoltaic element has a problem with lower conversion efficiency, because its film quality is degraded as compared with that of crystal silicon photovoltaic element or polycrystal silicon photovoltaic element, but to solve this problem, a so-called tandem cell or triple cell has been examined in which two or more series of semiconductor junction are laminated.

By the way, when such solar cells are used for, for example, the supply of electric power to general homes, the output of about 3KW is generally required, wherein when a solar cell having a conversion efficiency of 10 % is used, the solar cell must be as large as 30 m² or greater. However, on the solar cell fabricating process, it is difficult to fabricate nondefective solar cells over large area, wherein in polycrystal, for example, low resistive regions may arise at grain boundary portions, or in this film solar cells of amorphous silicon type, pinholes or defects may occur due to influence of dusts in forming a semiconductor layer film, causing a shunt or short, which is known to significantly decrease the conversion efficiency. The cause of producing a pinhole or a defect and its influence will be described in more detail. For example, in amorphous silicon type solar cells having deposition on a stainless substrate, the substrate surface cannot be said to be a complete smooth surface, and may comprise flaws, dents, or spike-like projections, or is provided with an irregular back reflector for the purpose of irregularly reflecting light against the substrate, so that a thin film semiconductor having a thickness of about 10 nm such as in the p-type or n-type semiconductor region cannot cover the surface entirely, or pin holes may arise due to contaminants produced in forming films as another cause. Also, the semiconductor between a lower electrode and an upper electrode of solar cell may be lost by a pinhole, placing the lower electrode and the upper electrode into direct contact, or a spike-like defect of substrate may make contact with the upper electrode. When there is a shunt or short of low resistance even if the semiconductor is not completely lost, the -electric current generated by light will flow parallel to the upper electrode into a low resistive portion of the shunt or short, causing generated current to be lost. With such current loss, the open voltage of solar cell decreases.

In amorphous silicon type solar cells, because of typically high sheet resistance of semiconductor itself, a transparent upper electrode over the entire surface of semiconductor is used, or a conductive antireflection film made of SnO₂ or ITO(In₂O₃+SnO₂) is usually provided to suppress the surface reflection. Therefore, the electric current flowing into defect is quite significant even if the defect is minute. Further, when the defect location is away from the grid electrode for current collection or the bus bar, the current loss is relatively small because of great resistance when it flows into a defective portion, but conversely, when the defect is located under the grid electrode or bus bar, the electric current loss due to the defect is greater.

On the other hand, in the defective-portion with the pinhole, electric charges generated by a photovoltaic element may not only leak into the defective portion, but also ionic substances are produced and grown due to interaction with water contents, whereby in using the solar cell, the electric resistance at detective portion decreases gradually with the elapse of service time, and there occurs a phenomenon that the conversion efficiency characteristic may be degraded.

When a short occurs as above, the current loss can be reduced by removing or insulating the upper electrode at that region. A method of selectively removing the upper electrode in the shunt or short portion has been disclosed in U.S. Patent No. 4,454,970, which teaches that the solar cell is immersed in electrolytic solution, and the short portion can be removed by etching while applying a bias to the solar cell. However, even if the upper electrode is removed by etching, there is a problem that a short may occur again when a grid is provided in the shunt portion.

A solution for such problem is to raise the contact resistance with a transparent electrode, a grid electrode or a bus bar by selectively covering only the defective portion with an insulator material or a material having high enough resistance to substantially prevent the shunt or short, and serves as effective means for preventing the decrease in conversion efficiency. A method of selectively covering for insulation only the defective portion includes detecting the defective portion of solar cell with a detector, and thereafter applying an insulating material to the detected defective portion by using an applicator, as disclosed in U.S. Patent No. 4,451,970. Or there is a method as disclosed in U.S. Patent No. 4,197,141 in which a polycrystal solar cell is immersed in the electrolytic solution to oxidize the crystal grain boundaries of polycrystal or the defective portion caused by lattice unconformity by applying an electric field, deposit an insulating substance on the defective portion, or etch the defective portion.

The former invention as disclosed has the problem that both the detector for defective portion and the applicator may constitute bulky apparatuses, which only allow the detection for the greater range than the size of actual defect, and further the insulation may extend over unnecessary portions, and be highly swollen, so that the grid cannot be printed. Also, the latter invention as disclosed, which has a concept of selectively depositing the insulating material, is involved in an example of anodizing the defective portion of gallium arsenide solar cell, wherein no disclosure of a silicon type solar cell is provided. Also, it includes depositing a metallic oxide such as aluminum, chromium, or copper, and no disclosure for the deposition of an organic polymer material is provided.

As above described, with the conventional method, the insulating material may attach to a greater extent than necessary, so that the performance of solar cell may be degraded. With either method, it is difficult to say that only the defective portion can be completely insulated with no other bad effects, whereby there was a problem that remarkable reduction in performance cannot be avoided when it is applied to practical solar cells. Such problem was a great problem also arising in the TFT thin film semiconductors deposited in a large area.

Additionally, an article by M. Matsumara et al., J. Appl. Phys. 61(4), 1648 (1987) discloses an electrochemical treatment of silicon solar cells, wherein the device degradation due to pinholes is prevented by (i) the removal of the TCO (transparent conductive oxide) layer at the pinhole and by (ii) the deposition of an insulating material at the pinhole. Particularly, the electrochemical polymerization of organic materials is exemplified as a method (ii).

Moreover, EP-A- 500 071 discloses a process for producing a defect-free photoelectric conversion device wherein an insulating material is deposited selectively at each of the defective portions. This is accomplished by electrolytic treatment.

An object of the present invention is to solve the aforementioned problems associated with semiconductor elements, and to provide a method for compensating defects in a semiconductor.

Another object of the present invention is to provide a fabrication method and apparatus for a semiconductor element higher reliable and favorable in mass production.

### SUMMARY OF THE INVENTION

According to the present invention, the above objects are achieved by a method for compensating defects in a semiconductor, including the steps of forming a dielectric breakdown region around a low resistive defective portion of a semiconductor region; and selectively electrodepositing said dielectric breakdown region with an anion or cation resin for insulation to form a region comprising a cation or anion electrodeposition region.

Moreover, the above objects are achieved by an apparatus for carrying out the above described method, including forming treatment means for yielding dielectric breakdown around a low resistive defective portion of a semiconductor region; and electrodeposition means for selectively covering for insulation said dielectric breakdown region with an anion or cation electrodeposition resin.

The preferred embodiments are set out in the dependent claims.

### BRIEF DESCRIPTION OF THE DRAWINGS

Figs. 1A and 1B are schematic views showing the constitution of a solar cell which is obtained by the method according to the present invention.

Fig. 2 is a schematic view showing the constitution of a solar cell which is obtained by the method according to the present invention.

Figs. 3A, 3B, 3C and 3D are schematic views showing each process of defect sealing according to the present invention.

Figs. 4A, 4B, 4C and 4D are schematic views showing each process of defect sealing according to the present invention.

Fig. 5 is a schematic constitution of an electrodeposition apparatus.

Fig. 6 is a schematic view showing an apparatus for forming treatment.

Fig. 7 is a schematic view showing an apparatus for passivation treatment.

Fig. 8 is a schematic constitutional view of an apparatus suitable for the electrodeposition by a roll-to-toll method.

### DETAILED DESCRIPTION OF THE PREFERRED EMBODIMENTS

The embodiments of a method for compensating defects in a semiconductor according to the present invention will be described below with reference to the drawings.

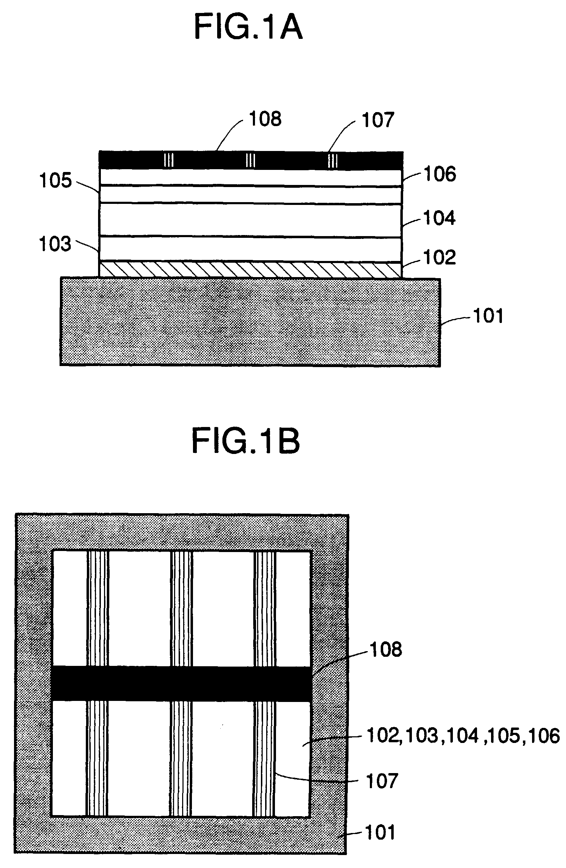

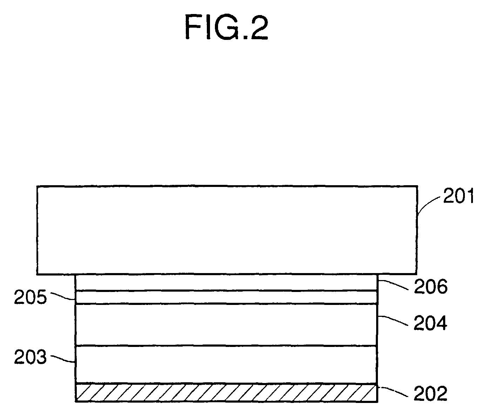

A photovoltaic element which is obtained by a preferred embodiment of the present invention is shown schematically in Figs. 1A, 1B and Fig. 2. Fig. 1A is a cross-sectional view of an amorphous silicon type solar cell in which light is incident from the semiconductor region side on the substrate, and Fig. 1B is a plan view of the solar cell of Fig. 1A, as viewed from the light incident side. Also, Fig. 2 is a thin film solar cell made of amorphous silicon deposited on a translucent substrate such as glass, wherein light penetrates through an insulating substrate such as glass.

In Figs. 1A, 1B and Fig. 2, 101, 201 are substrates, 102, 202 are lower electrodes (a conductive layer), 103, 203 are n-type semiconductor regions, 104, 204 are i-type semiconductor regions, 105, 205 are p-type semiconductor regions, 106, 206 are upper electrodes (transparent conductive layers), 107 is a grid electrode, and 108 is a bus bar.

The substrates 101, 201 are members for mechanically supporting the semiconductors 103, 104, 105, 203, 204, 205 in the thin film solar cell made of amorphous silicon. When the substrate is electrically conductive, it can be also used as the electrode. The substrates 101, 201 are required to have a heat resistance to withstand the heating temperature when forming the semiconductor film, but may be electrically conductive or insulating. Specific examples of electrically conductive materials include metals such as Fe, Ni, Cr, Al, Mo, Au, Nb, Ta, V, Ti, Pt, Pb, Ti, or their alloy, for example, a thin plate made of brass or stainless steel, and its complex, carbon sheet, and galvanized sheet iron. And examples of electrically insulating materials include films or sheets made of a heat resisting synthetic resin such as polyester, polyethylene, polycarbonate, cellulose acetate, polypropylene, polyvinylchloride, polyvinylidene chloride, polystyrene, polyamide, polyimide, or epoxy, or their complex with glass fiber, carbon fiber, boron fiber, or metallic fiber, a thin plate of such a metal or a resin sheet with the surface coated with a metallic thin film of a dissimilar material and/or an insulating thin film of SiO₂, Si₃N₄, Al₂O₃, AlN by sputtering, vapor deposition or galvanizing, glass, and ceramics.

The lower electrodes (conductive layers) 102, 202 are provided on the opposite side of the light incident side to the semiconductors 103, 104, 105, 203, 204, 205 to take out the generated electric power, and are required to have a work function of making ohmic contact with the semiconductors 103, 203. Examples of the materials may include so-called metallic simple substances such as Al, Ag, Pt, Au, Ni, Ti, Mo, W, Fe, V, Cr, Cu, stainless, brass, nichrome, SnO₂, In₂O₃, ZnO, ITO, or their alloy, and transparent conductive oxides (TCO). The surface of lower electrode is preferably smooth but may be irregular if irregular reflection of light is desired to occur. In the constitution of Figs. 1A and 1B, when the substrate 101 is electrically conductive, it is unnecessary to provide the lower electrode 102 specifically.

The semiconductor for photovoltaic element for use with the present invention may be a compound semiconductor such as pin junction non-single crystal silicon, pn junction polysilicon and CuInSe₄/CdS. In amorphous silicon type solar cells, examples of the semiconductor material constituting i-type semiconductor regions 104, 204 may include a-Si:H, a-Si:F, a-Si:H:F, a-SiGe:H, a-SiGe:F, a-SiGe:H:F, a-SiC:H, a-SiC:F, or a-SiC:H:F for so-called IV-group or IV-group alloy amorphous semiconductors.

The photovoltaic element which is obtained according to the present invention is applicable to a so-called tandem cell or triple cell wherein two or more layers of semiconductor junction are laminated for the purpose of improving the spectral sensitivity or voltage.

Under electrodes (transparent conductive layers) 106, 206 are electrodes for taking out the electromotive force generated by the semiconductor, and are paired with respective lower electrodes. Such an upper electrode is required for the semiconductor having a high sheet resistance, such as amorphous silicon type semiconductor, but is not specifically required for the crystal-type solar cell because of its low sheet resistance. Also, the upper electrode must be transparent because it is located on the light incident side, and thus is referred to as a transparent electrode.

The upper electrode desirably has a light transmittance of 85 % or greater to allow sun light or the light from a white fluorescent lamp to be absorbed efficiently into the semiconductor, and further desirably has an electrical sheet resistance of 100Ω/□ or less to allow the current generated by light to flow across the semiconductor transversely. The materials having such characteristics may include metallic oxides such as SnO₂, In₂O₃, ZnO, CdO, CdSnO₄, and ITO (In₂O₃+SnO₂).

Electrodeposition resin is used to insulate the short or shunt portion generated by various defects such as a pinhole, grain boundary, and a spike-like defect in the substrate 101 and the lower electrode 102 (or an upper electrode 206), and further has an additional feature of improving the moisture resistance. The shunt resistance of solar cell is ideally infinite, but the conversion efficiency of solar cell is not affected by a shunt resistance of about 10³ to 10⁶Ωcm². However, if a shunt or short is present due to defect, with a shunt resistance of 1KΩcm² or less, the conversion efficiency will remarkably decrease.

Electrodeposition resin must be deposited directly on the defective portion. The electrodeposition process may be made immediately after the formation of semiconductor 105, 203 to prevent adequately the occurrence of defects in the semiconductor, or after the formation of an upper electrode 106 (or a lower electrode 202).

The skeletal resin for electrodeposition resin having insulating and moisture proof properties is appropriately selected as desired from acrylic resin, polyester resin, epoxy resin, urethane resin, fluororesin, melamine resin, and butadien resin. Also, to effect electrophoresis for such resin in an aqueous solution, it is necessary to introduce a functional group for ionizing the resin to produce ions in the aqueous solution. Examples of the functional group may include a carboxyl group and an amino group. Electrodeposition paints with the above-cited resin dispersed can be classified into a cation type and an anion type in accordance with the polarity of a functional group. Based on a different polarity, they are appropriately selected in accordance with the desired characteristic.

Further, to cure the electrodeposition resin by heating, a functional group of causing a crosslinking reaction, such as melamine crosslinking, carbon-carbon double bond or urethane bond, should be appropriately introduced into the skeletal resin or side chain.

On the other hand, the film of electrodeposition resin is preferably not formed on other than the defective portion of solar cell, for which it is required that unnecessary paint is easily washed off after electrodeposition. Accordingly, the minimum film forming temperature (MFT) as desired is 50°C or greater.

To obtain an uniform film of electrodeposition resin, it is preferable that the resin is stably suspended in the solution without precipitation. For this purpose, the resin is desirably in the form of micell of an appropriate size. The grain diameter of the micell is desirably from about 10 to 100nm, desirably in the monodispersed system. The molecular weight of skeletal resin constituting the micell is preferably about 1000 to 20000 in the number average molecular weight. For the improvement of light resistance, heat resistance, moisture resistance, and selectivity of defective portion, it is possible that a filler such as an inorganic pigment, ceramics, glass frit, and particulate polymer is dispersed in the electrodeposition resin, and it is preferred that such filler is appropriately selected as desired. To insulate the defective portion of solar cell selectively and effectively, a greater electrodeposition film weight per unit quantity of electricity is preferable, for which Coulomb efficiency of electrodeposition paint is preferably 10mg/C or greater.

The solvent of electrodeposition paint used may be a solution containing an acid or alkali having a concentration at which solar cell components such as a transparent electrical conductor, a semiconductor region and a conductor are not readily dissolved, or a solution containing metallic salt thereof. Note that such metallic salt may be composed of a metal having a negative normal electrode potential, wherein the hydrogen overvoltage is smaller than the absolute value of normal electrode potential. Electrodeposition paint is used by diluting it with deionized water, the preferable range for film formation containing a solid component of 1% to 25%. Also, the electrical conductivity of liquid is desirably in a range of about 100µS/cm to 2000µS/cm, so that the resin can be stably suspended, easily bringing about electrophoresist, and readily allowing deposition on the desired defective portion.

In some fabrication methods of solar cell, the solvent is used or the thermal process is performed, after electrodeposition, in which it is preferred that the deposited electrodeposition film is not affected by such treatment. Also, the defective portion of solar cell itself does not contribute to the power generation, but even when the electrodeposition film is selectively deposited, there is a possible instance where the film may be deposited in a wider area than the substantial area of a defective portion, for which it is preferable-that the electrodeposition paint is of a light transmissive material so as not to prevent light from entering the normal portion. Further, considering various environments where the solar cell is used outdoors, excellent weather resistance, and the stability against heat, humidity and light are required. Also, since the solar cell may be flexed or impacted during use in some cases, it is preferred that the solar cell has a mechanical strength and a peel strength. The thickness of electrodeposition film can be appropriately selected depending on the kind of resin, considering that the electrical insulating property and the moisture resistance should be retained and the light transmissivity with the photovoltaic element must not be impaired, but typically it is preferable to have a thickness from approximately 500nm to 50µm.

Grid electrode 107 is an electrode for taking out the electromotive force generated in the semiconductor regions 103, 104, 105, and referred to as a collector electrode. The grid electrode 107 has a suitable arrangement determined from the sheet resistance of semiconductor 105 or upper electrode 106, but is formed in substantial comb-type, wherein it is preferable that the grid electrode is narrow with respect to the light incident plane and high in the light incident direction not to prevent light incidence. The grid electrode has preferably a specific resistance of 10⁻²Ωcm to 10⁻⁵Ωcm, which is not a series resistance with the solar cell. Examples of the material of the grid electrode include metallic materials such as Ti, Cr, Mo, W, Al, Ag, Ni, Cu, Sn, and conductive pastes composed of a power of metal such as Ag, Pt, Cu, C and an alloy thereof with polymer binder or binder solvent blended therein at an appropriate ratio to form a paste.

Bus bar 108 for use in the present invention is an electrode for further collecting the current flowing through the grid electrode 107 to one end. Examples of electrode material may include metals such as Ag, Pt and Cu, or C, and their alloy, in which a wire- or foil-like electrode is pasted, or the same conductive paste as the grid electrode 107 may be used. Such foil may be, for example, a copper foil, a tin-plated copper foil, or a foil with adhesive in some cases.

The solar cell as fabricated above is formed as a module by encapsulation with any of well-known methods in order to retain an excellent weather resistance and a mechanical strength in outdoor uses. A specific example of encapsulation material for use is preferably EVA (ethylene-vinyl-acetate) from the respects of adhesiveness, weather resistance, and cushioning property with the solar cell for the adhesive layer. Also, to improve the moisture resistance and the damage resistance, a surface protective layer made of fluorine-type resin is laminated. Examples of fluorine-type resin may include, for example, a polymer TFE of tetrafluoroethylene (Teflon, manufactured by Du Pont), a copolymer ETFE of tetrafluoroethylene and ethylene (Tefzel, manufactured by Du Pont), polyvinyl fluoride (Tedler, manufactured by Du Pont), and polychlorofluoroethylene CTFE (Neofron, manufactured by Daikin Kogyo). The weather resistance can be improved by adding an ultraviolet absorbent to such resin. The method of laminating such resin on the solar cell substrate may include laminating it by heat in vacuum, using an apparatus available in the market such as a vacuum laminator.

The fabrication method of a photovoltaic element according to the present invention relies on any one of well-known methods as far as the fabrication of a semiconductor (an n-type semiconductor region, an i-type semiconductor region, a p-type semiconductor region), a lower electrode, an upper electrode, a grid electrode, and a bus bar is concerned.

The film formation method for semiconductor may be selected as desired from the methods such as vapor deposition, sputtering, RF plasma CVD, mic-rowave plasma CVD, ECR, heat CVD, and LPCVD. The semiconductor is formed, for example, by plasma CVD with a silane gas for non-single crystal silicon, by sheet formation of molten silicon for polycrystalline silicon, or by deposition such as electron beam deposition, sputtering or electrolysis of electrolyte for CuInSe₄/CdS. Industrially, a plasma CVD method is preferably adopted in which a source gas is decomposed by plasma and deposited on the substrate. Also, chemical reactor, a batch system or a continuous film forming system can be used as desired. The fabrication of valence controlled semiconductors can be achieved by introducing and decomposing a PH₃ or B₂H₆ gas containing constituent atom such as phosphorus or boron, together with silane gas.

The semiconductor material constituting the p-type semiconductor region or n-type semiconductor region suitably used with the photovoltaic element of the invention can be obtained by doping-a valence control agent into a semiconductor material constituting the i-type semiconductor region. In obtaining a deposited film of IV-group in the periodic table, the valence control agent used for the p-type semiconductor may be a compound containing an element of III-group in the periodic table. Examples of III-group element may include B, Al, Ga, and In. The valence control agent for the n-type semiconductor may be a compound containing an element of V-group in the periodic table. Examples of V-group element may include P, N, As, and Sb.

Lower electrode is fabricated by plating, vapor deposition or sputtering. The fabrication method of the upper electrode is appropriately selected as desired from the methods such as resistance heating vapor deposition, electron beam heating vapor deposition, sputtering, and spraying.

The forming, short passivation and electrodeposition treatments of the present invention will be described below which are performed in the process of fabricating the solar cell with a configuration of Figs. 1A and 1B, as well as the solar cell having a configuration of Fig. 2.

The forming treatment is a process of decreasing greatly the electrical resistance at the defective portion by applying a voltage between the conductive layer and the semiconductor region (or a transparent conductive layer) of a photoelectric conversion element having the conductive layer and the semiconductor region (or further transparent conductor) formed on the substrate to subject the defective portion (having a lower electrical resistance than its surroundings) to dielectric breakdown selectively and compulsorily. The applied voltage is in a range of approximately 2 to 10V which is substantially applied between the conductive layer and the semiconductor layer (or a transparent conductive layer), wherein it is necessary to select a voltage at which the normal portion of the photoelectric conversion element does not undergo dielectric breakdown. Also, the applied current used is reverse-bias direct current or current alternating between forward-bias and reverse-bias at a predetermined period with respect to the photoelectric conversion element.

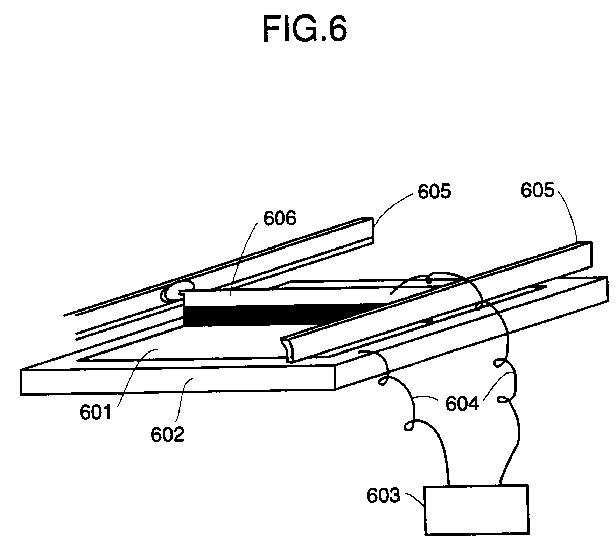

One example of a forming treatment apparatus is illustrated in a schematic view of Fig. 6. 601 is a photoelectric conversion element to which forming treatment is applied, and is placed on an electrically conductive carrier board 602 with a substrate down for the electrical connection between the conductive layer and the carrier board. 603 is a power source, 604 is a conductive lead, 605 is a driver portion for a voltage applier, and 606 is the voltage applier. The voltage applier serves to apply a voltage to the surface of semiconductor (or a transparent conductive layer) left in slight contact state, as well as applying a uniform voltage to the entire surface of the photoelectric converter 601 while moving in parallel to the photoelectric converter 601. The voltage applier is preferably fabricated by using an electrically conductive soft brush or rubber roller which imposes no damage on the surface of the photoelectric converter 601. The relative movement rate (forming treatment rate) between the voltage applier and the photoelectric converter should be as fast as possible from the viewpoint of productivity, and is preferably in a range from about 20cm/min to 300cm/min to assure the reliable treatment.

While in Fig. 6, the voltage applier 606 is moved, the photoelectric conversion element 601 can be moved, with the voltage applier 606 fixed, to the same forming effect. This latter is effective, particularly when the photovoltaic element by roll to roll method is moved.

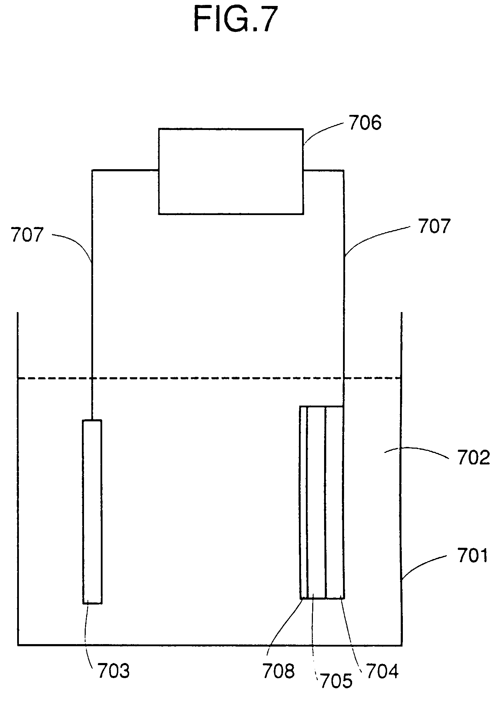

The short passivation treatment is to electrochemically reduce selectively the defective portion of a photoelectric converter having a conductive layer, semiconductor regions, and a transparent conductive layer formed in sequence on the substrate, thereby dissolving and removing partially or entirely the material at the defective portion. An example of electrolytic apparatus to be used is illustrated in a schematic view of Fig. 7. An electrolytic bath 701 is filled with an electrolyte 702. An anode 703 electrically connected to a conductive member 707 and a cathode as a photoelectric converter are immersed in the bath. The conductive member 707 is connected to a DC power source 706. The conductive member on the cathode side is electrically connected to the conductive layer of photovoltaic element. In Fig. 7, a semiconductor region layer 705 and a transparent conductive layer 708 are formed in sequence on a substrate 704. The electrolyte may be an acid solution such as hydrochloric acid, nitric acid or sulfuric acid, an alkaline solution such as sodium hydroxide or potassium hydroxide, or a metallic salt solution, having a concentration at which the transparent conductive layer is not easily dissolved. Such metallic salt may be a salt composed of a metal having a negative normal electrode potential, in which the hydrogen overvoltage is smaller than the absolute value of normal electrode potential. Specifically, examples thereof include aluminum chloride, magnesium sulfate and sodium chloride. For more efficient electrolysis, the electrical resistance of electrolyte needs to be sufficiently low, and is preferably set in a range from about 0.05 to 1.0S/cm.

The materials for the anode 703, which is a counter electrode, may include platinum, titanium and graphite. The voltage to be applied to the cathode needs to be 2V or greater, considering the hydrogen overvoltage. Also, the electrolytic current density is preferably from 0.1 to 50mA/cm² to prevent the side reaction.

While in Fig. 7, the anode 703 which is an anode electrode and the cathode which is a photoelectric converter are immersed in the electrolyte, the anode and the cathode are only necessary to be placed via the interposition of the electrolyte, and specifically it will be appreciated that an anode vessel may be provided which is electrically connected to the power source 706 and contains an electrolyte therein, and the photoelectric converter is moved in contact with the surface of the electrolyte to dissolve the defective portion to be removed.

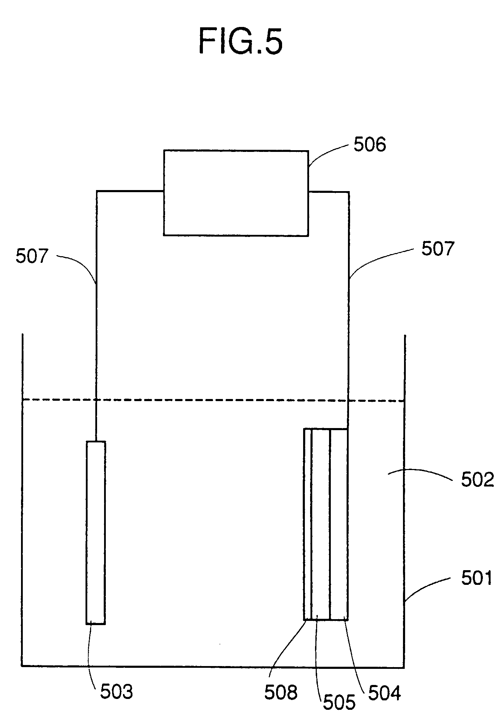

The process of selectively depositing the electrodeposition resin on the defective portion is performed by immersing a photovoltaic element having the defective portion and a counter electrode in the electrodeposition paint, and applying a voltage between the photovoltaic element and the counter electrode to deposit an electrodeposition film on the defective portion. A schematic electrodeposition vessel is illustrated in Fig. 5. Fig. 5 shows an example of conducting electrodeposition treatment for the photoelectric covnerter having an upper electrode formed thereon. 501 is an electrolyte bath, 502 is an electrodeposition paint liquid, 503 is a counter electrode, 504 is an electrically conductive substrate (substrate provided with a low electrode thereon), 505 is a semiconductor region, 506 is a power source, 507 is an electrically conductive member connecting respective electrodes to the power source 506, and 508 is a transparent conductive layer which is an upper electrode.

The terminal from the photovoltaic element may be drawn out of the conductive substrate or the lower electrode, as shown in Fig. 5. The material of the counter electrode 503 is required not to be corroded in the electrodeposition paint, wherein preferable examples thereof include platinum, nickel, and stainless which are corrosion resistant. Also, it is necessary for even electrodeposition that the area of the counter electrode 503 is at a fixed ratio relative to the area of solar cell, and it is preferable that the ratio of the photovoltaic element area to the counter electrode area, or a so-called electrode ratio, is in a range from 1/2 to 2/1. The anode-cathode distance between the photovoltaic element and the counter electrode 503 is an important factor for retaining the evenness of electrodeposition, the preferable range in view of various conditions such as the electric conductivity of electrodeposition paint 502 or the applied voltage being typically from 10mm to 100mm.

To selectively deposit the electrodeposition film on the defective portion of photovoltaic element, it is not preferable to expose the substrate and other conductive portions to the electrodeposition paint 502, when the substrate 504 is electrically conductive. Therefore, it is desirable that the surface of a conductive substrate 504 which is a back face of the photovoltaic element opposite the light incident side is covered with an insulating material such as a plastic film or a rubber magnet, or the electrodeposition paint and the photoelectric converter are only brought into contact. Also, if the photovoltaic element is illuminated by light, the normal portion other than the defective portion has its resistance reduced by photoelectromotive force, resulting in a lower ratio of the resistance of the defective portion to that of the normal portion, and thus a lower selectivity. Accordingly, it is possible to provide a desired selectivity by conducting the electrodeposition in the darkness if necessary.

The electrodeposition can be made either through a constant voltage or constant current anodizing process, but in the constant voltage anodizing process, for example, the votlage to be applied to the photovoltaic element should be a voltage at or above a hydrogen generating voltage which is calculated from the electrode voltage defined by Nernst's equation, and more specifically, a voltage which is the sum of a theoretical decomposition voltage of water plus an overvoltage, or 2 volts or greater. Further, the preferable voltage range may be different, depending on the electrical conductivity of electrodeposition paint or whether the polarity of the voltage applied to the photovoltaic element is reverse-biased or forward-biased, and thus can be determined substantially in a range from about 2V to 200V, in view of various respects such as the constitution and area of solar cell, the material property such as the electrical conductivity of electrodeposition paint, the polarity of applied voltage, and the degree of light quantity (the dielectric breakdown voltage will vary in reverse-bias).

Also, because a part of the applied voltage is applied to the solar cell, the voltage must be within a range in which the photovoltaic element does not undergo dielectric breakdown, when reverse-biased. Conversely, when forward-biased, the photovoltaic element has a forward current flowing therethrough, with the selectivity degraded, so that the electrodeposition film may be likely deposited on the portion other than the defective portion. From this respect, the voltage not impairing the selectivity must be set.

In the electrodeposition with the constant current method, the current density is preferably in a range from 0.1 to 10A/cm², depending on the shunt degree of the photovoltaic element, to form a dense electrodeposition film.

In either of the constant voltage and constant current anodizing methods, the way of determining the termination of electrodeposition relies on using the time or the coulomb quantity. Since the electrodeposition paint film having a high resistance will not be formed in the portion reaching a certain film thickness, it is possible that electrodeposition is automatically terminated on the defective portion, depending on the constitution of photovoltaic element, thereby allowing no current to flow. However, when a forward bias is applied to the photovoltaic element, the deposition will extend over the normal portion with the elapse of time, even though some selectivity may exist at the early time of electrodeposition, whereby it is preferable to control the termination of electrodeposition with the time or the coulomb quantity, as previously described.

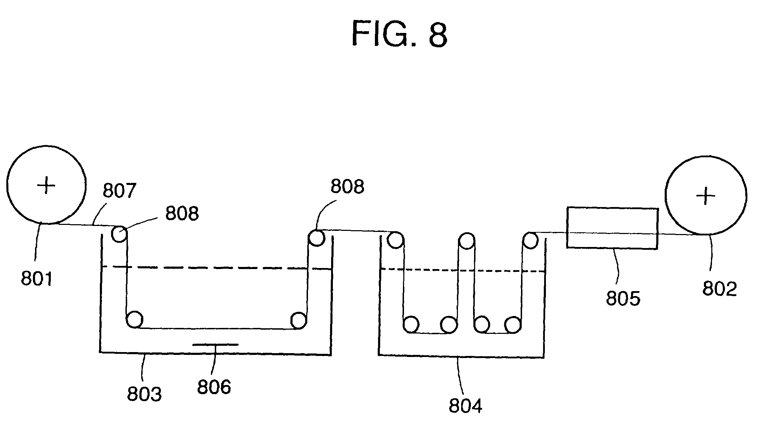

In the above description, the photovoltaic element is sheet-like, and the electrodeposition process is a leaf processing, but can be performed on the roll-to-roll basis which allows for the continuous processing, as necessary. An apparatus suitable for the roll-to-roll processing is shown in Fig. 8. In a preferred embodiment as shown in this figure, a photovoltaic element 807 is an nip-type amorphous silicon deposited on a stainless substrate, on which an upper electrode of ITO is formed. The photovoltaic element 807 is delivered from a delivery roll 801 consecutively and immersed in an electrodeposition vessel 803, whereby a voltage is applied with respect to a counter electrode 806. It is passed through a cleaning vessel 804 and a drying furnace and then wound around a take-up roll 802. Before immersion in the electrodeposition vessel 806, a masking film for the back surface of photovoltaic element is delivered from a plastic film roll not shown and bonded with the back surface of the photovoltaic element. After completion of the electrodeposition, it is peeled off again and wound after cleaning and drying. A voltage is applied between a conductive roller 808 in contact with the substrate of photovoltaic element and the counter electrode 806 installed within the electrodeposition vessel.

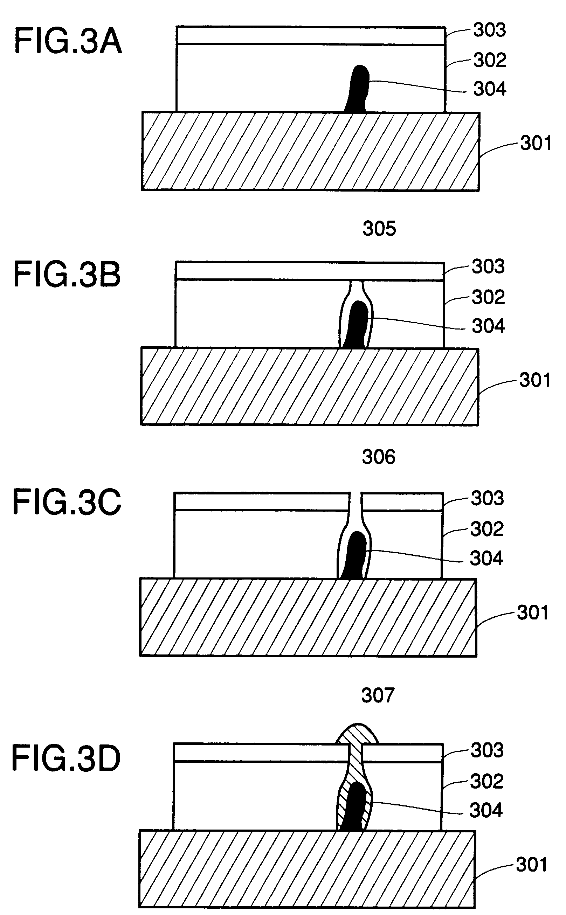

The above-described series of processings will be described with reference to Figs. 3A to 4D.

In Fig. 3A, 301 is a conductive substrate, 302 is a semiconductor region, 303 is a transparent conductive layer, and 304 is a defective portion. Fig. 3B illustrates a state after the forming treatment, in which 305 is a portion with reduced electrical resistance near the defective portion by the forming treatment. Fig. 3C illustrates a state after the short passivation process, in which 306 is a portion with lower electrical resistance which is dissolved and removed by short passivation. Fig. 3D illustrates a state after the electrodeposition processing, in which 307 is a sealed cavity and defective portion formed by the short passivation, which is sealed by an electrodeposition resin.

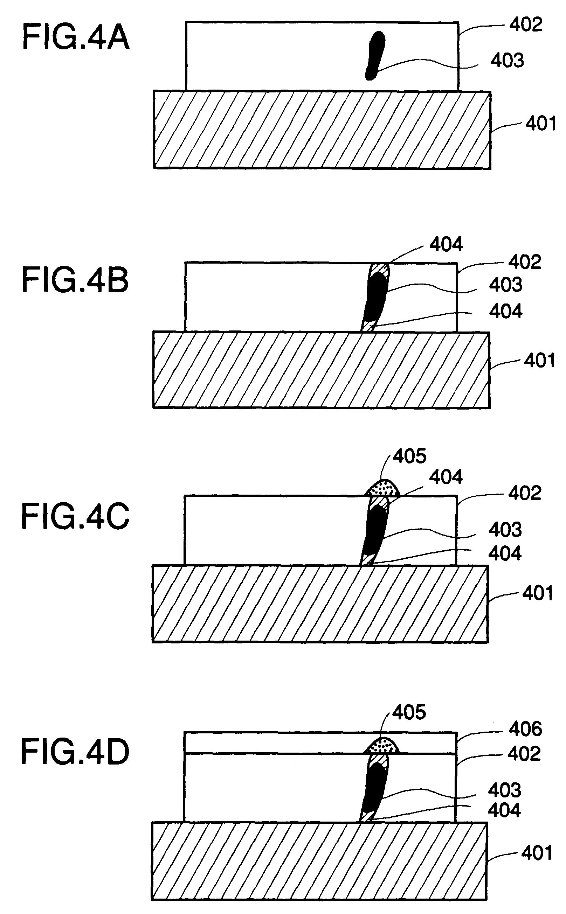

In Fig. 4A, 401 is a conductive substrate, 402 is a semiconductor region, and 403 is a defective portion. Fig. 4B illustrates a state after the forming process, in which 404 is a portion with reduced electrical resistance near the defective portion by the forming. Fig. 4C illustrates a state after the resin electrodeposition process, in which 405 is an electrodeposition portion. Fig. 4D illustrates a state after ITO deposition, in which 406 is an ITO deposited on the resin with the semiconductor layer and the defective portion sealed.

While in Figs. 3A - 3D and Figs. 4A - 4D, the semiconductor region and the transparent conductive layer are formed on the conductive substrate, it will be appreciated that the transparent conductive layer, the semiconductor regions and the conductive layer are formed on the transparent substrate, as previously described.

The methods of forming the grid electrode 107 in comb-like shape include vapor deposition such as sputtering, resistance heating or CVD, patterning by etching after vapor deposition of a metallic layer over the entire face, forming directly a grid electrode pattern with photo assisted CVD, plating after forming the mask of the grid electrode pattern, and printing the conductive paste.

Electrode of conductive paste can be fabricated with good productivity by using the screen printing method. The screen printing method is a method in which the electrically conductive paste is used as the print ink with a screen having a desired pattern applied on the mesh of nylon or stainless, the width of the electrode being about 50 µm at minimum. The printing machine is preferably a screen printing machine. The conductive paste subjected to screen printing is heated in a drying furnace for the crosslinking of binder and the volatilization of a solvent.

In the following, the constitution and fabrication method of a solar cell of the present invention will be described in more detail by way of example, but the present invention is not limited to such examples.

### Example 1

### (1-1)

A solar cell having a layer constitution as shown in Fig. 1A was fabricated. First, a substrate 101 (30cm x 30cm, 0.2mm thick) manufactured by SUS430BA which has been subjected to sufficient degreasing and washing, was placed within a DC sputtering apparatus (not shown) in which a lower electrode 102 was formed by depositing Cr 200nm thick. The substrate 101 was taken out and placed within an RF plasma CVD film forming apparatus (not shown) for the deposition of an n-type semiconductor region 103, an i-type semiconductor region 104, and a p-type semiconductor region 105 in this sequence. Thereafter, an alloy of In and Sn was vapor-deposited by resistance heating in a vapor deposition apparatus with resistance heating (not shown) to deposit a 70nm thick transparent upper electrode 106 having antireflection effect, whereby the solar cell was fabricated.

Next, the solar cell was formed in the forming treatment apparatus of Fig. 6. The applied voltage was 3V of reverse bias in direct current, with the processing rate being 180cm/min. The solar cell after the forming treatment was subjected to passivation treatment in a short passivation apparatus of Fig. 7. Next, 10% AlCl₃ aqueous solution was filled in an electrolytic bath, and the back side of the solar cell was covered with an insulating film made of plastic, and immersed in the electrolytic bath of Fig. 7. A voltage of minus 4V was applied to the side of a conductive substrate for the solar cell, and held for three seconds. In this process, ITO of the shunt portion and part of the defective portion were removed. After washing, drying was conducted.

Subsequently, the substrate 504 for the solar cell which had undergone various treatments as previously mentioned was covered on the back surface side thereof with an insulating film of plastic, and immersed in the electrolytic bath of Fig. 5 so that the back surface of the substrate 504 was not subjected to electrodeposition. The counter electrode 503 used was an SUS304 stainless plate as large as 30cm x 30cm, with the back surface of the substrate 504 sealed using an insulating film made of plastic. The electrodeposition paint 502 used was acrylic-type cation electrodeposition paint containing a 20% solid component. A minus 10V voltage was applied to the substrate 504, and held for ten seconds to conduct electrodeposition. The solar cell was pulled up from the electrolytic bath, washed fully with pure water to wash off unreacted electrodeposition paint, placed in an oven at 50°C, and left for thirteen minutes to dry out water contents. Thereafter, the temperature of the oven was elevated at a rate of 10°C/min, and held for thirty minutes after reaching 180°C, to cure the electrodeposition resin.

Thereafter, the solar cell was taken out of the oven, and after cooling, a part of the solar cell was cut out. The observation for the surface of ITO by a scan-type electron microscope showed that semi-spherical deposits, about 5 µm to 30 µm in diameter, were spotted on the surface of the ITO508. The infrared absorption spectrum analysis using an FTIR with microscopic feature on that portion confirmed that there was absorption peculiar to acrylic resin, and electrodeposition paint was deposited. Further, the observation for OBIC (an optical excitation current microscope) image using a 2LM21 scan-type laser microscope manufactured by Laser Tec confirmed that only the deposited portion of electrodeposition paint generated no power so that the film was deposited only on the shunt portion.

Next, the solar cell after the electrodeposition process was installed on a screen printing machine (not shown) in which grid electrodes 107, 100 µm wide and 8 cm long, were printed at an interval of 1 cm. The conductive paste contained 70 parts of Ag filter, 30 parts of polyester binder (volume ratio), and 20 parts of ethyl acetate as the solvent. After printing, the solar cell was placed in the oven, and held at 150°C for thirty minutes to cure the conductive paste.

Further, the bus bar 108 of copper foil with an adhesive 5 mm wide as shown in Fig. 1B was bonded to fabricate a single cell of 30 cm square. With the same method, ten samples were fabricated.

Next, the encapsulation of these samples was conducted in the following way. EVA was laminated both on the front and back surfaces, and a fluororesin film ETFE (ethylene tetrafluoroethylene) (tradename Tefzel, manufactured by Du Pont) was further laminated on the outer surfaces thereof. Subsequently, the samples were placed in a vacuum laminator and held at 150°C for sixty minutes for conducting the vacuum lamination, so that a solar cell module was fabricated.

The initial characteristics of the solar cell module obtained were measured as follows.

First, measuring the voltage/current characteristics of the samples in the dark state indicated that the shunt resistance as obtained from the slope near the origin had excellent values such as 500 KΩcm² to 300 KΩcm², with less dispersion. Next, using an artificial sunlight source (hereinafter referred to as a simulator) having a sunlight spectrum of AM 1.5 global and a light quantity of 100 mW/cm², the measurement for the solar cell characteristics indicated that the conversion efficiency was 6.8% ± 0.5%, indicating excellent characteristics and with less dispersion.

The reliability test for these samples was conducted based on a temperature and humidity cycle test A-2 defined in the environmental test method and the durability test method for crystal-type solar cell modules according to Japanese Industrial Standards C8917.

First, with those samples placed in a thermo-hygrostat capable of controlling the temperature and humidity, the cycle test of changing the temperature from -40°C to +85°C (relative humidity of 85%) was repeated 10 times. Then, for the samples after completion of the test, the solar cell characteristics were measured in the same way as at the initial time, using a simulator, so that the conversion efficiency was 95% in average of the initial conversion efficiency, with no significant degradation. Also, the shunt resistance was measured, so that it decreased about 10%, with no significant degradation. From these points, it could be found that a series of processings of the present invention had excellent effects.

From the results of this example, it could be found that the solar cells fabricated with the solar cell fabrication method had good yield, excellent characteristics, and high reliability.

### (1-2)

The sealing of defects for the solar cell was conducted in the same way and procedure as the example 1-1, except that in the electrodeposition, the electrodeposition paint used an acrylic-type anion electrodeposition paint containing 10% solid component, and a plus voltage of 10 V was applied to the substrate.

Thereafter, a part of the solar cell was cut out. The observation for the surface of ITO by a scan-type electron microscope showed that semi-spherical deposits, about 5 µm to 30 µm in diameter, were spotted on the surface of the ITO508. The infrared absorption spectrum analysis using an FTIR with microscopic feature on that portion confirmed that there was absorption peculiar to acrylic resin, and the-electrodeposition paint was deposited. Further, the observation for OBIC image confirmed that only the deposited portion of the electrodeposition paint generated no power so that the film was deposited only on the shunt portion.

Next, by forming the grid electrode and the bus bar and conducting encapsulation, a solar cell module was fabricated. The measurement for the shunt resistance for obtained solar cell module showed 500 KΩcm² to 300 KΩcm², with excellent characteristic and less dispersion. Also, the conversion efficiency was 6.1% ± 0.5%, with excellent characteristics and less dispersion.

The solar cell characteristics after completion of test was 95% in average of the initial conversion efficiency, with no significant degradation. Also, the shunt resistance was measured, so that it decreased about 10%, with no significant degradation. From these points, it could be found that a series of processings of the present invention had excellent effects.

From the results of this example, it could be found that the solar cells fabricated with the solar cell fabrication method had good yield, excellent characteristics, and high reliability.

### (Comparative example 1)

For the comparison, a solar cell with the same constitution as in the example 1 was fabricated in the following way, without forming, short passivation and electrodeposition.

In the same way as in the example 1, the portions up to the upper electrode 106 were fabricated on a substrate 101. Next, grid electrodes 107 were printed in the same way. Further, a copper foil with adhesive was laminated as the bus bar 108, so that a single cell of 30 cm square was fabricated.

Next, encapsulation for this sample was conducted in the same way as in the example 1. The initial characteristics for obtained sample were measured in the same procedure as in the example 1, so that the conversion efficiency was 4.1%, and the shunt resistance was 3.8 KΩcm², it being revealed that the shunt resistance was lower than in the example 1 and thus the conversion efficiency was lower.

The reliability test for this sample was evaluated in the same way as in the example 1. After the completion of temperature and humidity cycle test, the solar cell characteristics were measured, so that the conversion efficiency was 86% of the initial value, with significant degradation indicated. Also, the measurement of shunt resistance indicated a decrease of about 20%, it being found that the shunt occurred after the completion of reliability test.

The shunt portion for this sample was confirmed as follows. First, a reverse bias of 1.5 V was applied to the sample. The shunt portion had a current flowing therethrough, and was heated, but the normal portion, reverse-biased, has no current flowing therethrough, and thus was not heated. In this state, the observation for the surface of the sample by an infrared detection camera showed the heat generating portion, revealing that there was a shunt under the grid electrode 107.

### (Example 2)

### (2-1)

Next, a solar cell with the constitution of Fig. 2 was fabricated substantially in the same way as in the example 1.

First, a transparent upper electrode 206 of SnO₂ was deposited on a glass substrate (Corning 7059) of 30 cm square, usinga vapor deposition apparatus (not shown). Thereafter, the upper electrode 206 was patterned by etching so that the sub-cells 2 cm wide were arranged with a gap 5 mm wide spaced. Next, using a metal mask, p-type semiconductor region 205, i-type semiconductor region 204, n-type semiconductor region 203 were deposited to substantially overlie over the upper electrode 206. Further, the substrate 201 having deposited up to the n-type semiconductor region 203 was placed within a sputtering apparatus (not shown) using a metal mask, to fabricate a lower electrode of aluminum, so that ten series of single cell of 30 cm square were fabricated.

Next, in the same way as in the example 1, the forming and short passivation treatments were conducted. Subsequently, the substrate 201 thus treated was immersed in an electrolytic bath 701 for the electrodeposition using an epoxy-type cation electrodeposition paint.

With the above fabrication method, 10 sheets of sample were fabricated. The initial characteristics for obtained samples were such that the conversion efficiency was 6.4% ± 1%, and the shunt resistance was from 350 to 200 KΩcm².

Next, the reliability test for this sample was evaluated in the same way as in the example 1. After the temperature and humidity cycle test, the measuremnnt for the solar cell characteristics indicated 97% of the initial value, with no degradation indicated. Also, the. measurement for the shunt resistance indicated almost no change.

From the results of this example, it could be found that the solar cells fabricated with the solar cell fabrication method had good yield, excellent characteristics, and high reliability.

### (2-2)

A solar cell module was fabricated in the same way as in the example 2-1, except that the electrodeposition was performed using an epoxy-type anion electrodeposition paint.

The initial characteristics for obtained solar cell module were such that the conversion efficiency was 6.0% ± 1%, and the shunt resistance was from 350 to 200 KΩcm². After the temperature and humidity cycle test, the measurement for the solar cell characteristics indicated 97% of the initial value, with no degradation indicated. Also, the measurement for the shunt resistance indicated almost no change.

From the results of this example, it could be found that the solar cells fabricated with the solar cell fabrication method had good yield, excellent characteristics, and high durability.

### (Example 3)

### (3-1)

A solar cell having a constitution as shown in Figs. 1A and 1B was fabricated substantially in the same way as in the example 1.

As in the example 1, on a substrate 101 (30 cm x 30 cm, 0.2 mm thick) manufactured by SUS430BA was formed a lower electrode 102. The substrate 101 was taken out and placed within an RF plasma CVD film forming apparatus (not shown) for the deposition of n-type semiconductor region 103, i-type semiconductor region 104, and p-type semiconductor region 105 in this sequence. Thereafter, a transparent upper electrode 106 having antireflection effect was deposited 70 nm thick.

Next, after the forming and short passivation treatments in the exact same way as in the example 1, the back side of the substrate 101 was covered with an insulating film made of plastic in the same way as in the example 1, and immersed in an electrolytic bath of Fig. 7. Then, the insulation treatment was made using a styrene-type cation electrodeposition paint. The substrate was washed sufficiently with pure water and had electrodeposition resin cured within an oven. Thereafter, the substrate 101 was taken out of the oven, and after cooling, a bus bar 108 of copper foil with adhesive was laminated thereon to fabricate a single cell of 30 cm square. With the same method, ten sheets of sample were fabricated.

Further, the encapsulation of these samples was conducted in the same way as in the example 1. The initial characteristic of the samples obtained was 6.5% ± 1%, with the series resistance being 4Ωcm², indicating excellent characteristics.

The durability characteristics for these samples was evaluated in the same way as in the example 1. After completion of the temperature and humidity cycle test, the solar cell characteristic was 98% of the initial value, with no degradation. The measurement for the shunt resistance indicates almost no change.

From the results of this example, it could be found that the solar cells fabricated with the solar cell fabrication method had good yield, excellent characteristics, and high durability.

### (3-2)

A solar cell module was fabricated in the same way as in the example 3-1, except that the electrodeposition was performed using a styrene-type anion electrodeposition paint.

The initial characteristics for obtained solar cell module were such that the conversion efficiency was 6.4% ± 1%, and the shunt resistance was 4Ωcm², indicating excellent characteristics. After the temperature and humidity cycle test, the measurement for the solar cell characteristics indicated 98% of the initial value, with no degradation indicated. Also, the measurement for the shunt resistance indicated almost no change.

From the results of this example, it could be found that the solar cells fabricated with the solar cell fabrication method had good yield, excellent characteristics, and high durability.

### (Example 4)

### (4-1)

A solar cell having a constitution as shown in Fig. 1 was fabricated in the process of electrodeposition after forming and short passivation treatments. First, as in the example 1, on a substrate 101 (30cm x 30cm, 0.2mm thick) manufactured by SUS430BA was formed a lower electrode 102. Thereafter, the substrate 101 was placed within an RF plasma CVD film forming apparatus (not shown) for the deposition of n-type layer 103, i-type layer 104, and p-type layer 105 in this sequence. As in the example 1, a transparent upper electrode 106 having antireflection effect was deposited 70nm thick.

Next, the forming and short passivation treatments were conducted in the exact same way as in the example 1. Thereafter, insulation treatment was conducted in an electrolytic bath of Fig. 7 using a fluorine-type cation electrodeposition paint. The substrate was washed sufficiently with pure water and cured by heating within an oven at 160°C for forty minutes. Thereafter, the substrate 101 was taken out of the oven, and after cooling, a bus bar 108 of copper foil with adhesive was laminated thereon to fabricated a since cell of 30cm square. With the same method, ten sheets of sample were fabricated.

Further, the encapsulation of these samples was conducted in the same way as in the example 1. The initial characteristics of the samples obtained were such that the conversion efficiency was 7.1% ± 1%, with the series resistance being 4Ωcm², indicating excellent characteristics.

The reliability test for these samples was performed in the same way as in the example 1. After completion of the temperature and humidity cycle test, the solar cell characteristic was 96% of the initial value, with no degradation. The measurement for the shunt resistance indicates almost no change.

From the results of this example, it could be found that the solar cells fabricated with the solar cell fabrication method had good yield, excellent characteristics, and high durability.

### (4-2)

A solar cell module was fabricated in the same way as in the example 4-1, except that the electrodeposition was performed using a styrene-type anion electrodeposition paint.

The initial characteristics for obtained solar cell module were such that the conversion efficiency was 7.1% ± 1%, and the shunt resistance was 4Ωcm², indicating excellent characteristics. After the temperature and humidity cycle test, the measurement for the solar cell characteristics indicated 98% of the initial value, with no degradation indicated. Also, the measurement for the shunt resistance indicated almost no change.

From the results of this example, it could be found that the solar cells fabricated with the solar cell fabrication method had good yield, excellent characteristics, and high durability.

### (Example 5)

### (5-1)

A solar cell having a layer constitution as shown in Figs. 1A and 1B was fabricated in the following way. First, a substrate 101 (30cm x 30cm, 0.2mm thick) manufactured by SUS430BA, which has been subjected to sufficient degreasing and washing, was placed within a DC sputtering apparatus (not shown) in which a lower electrode 102 was formed by depositing Cr 200nm thick. The substrate 101 was taken out and placed within an RF plasma CVD film forming apparatus (not shown) for the deposition of n-type semiconductor region 103, i-type semiconductor region 104, and p-type semiconductor region 105 in this sequence.

Next, the solar cell was formed in the forming treatment apparatus of Fig. 6. The applied voltage was 2.5V of reverse bias in direct current, with the treatment rate being 200cm/min.

Next, the back face side of the substrate 504 for the solar cell after the aforementioned treatments was covered with an insulating film made of plastic, and immersed in an electrolytic bath of Fig. 5 so that electrodeposition was not made on the back face of the substrate 504. The counter electrode 503 used was an SUS 304 stainless plate as large as 30cm x 30cm, with the back surface of the substrate 504 sealed using an insulating film made of plastie. The electrodeposition paint 502 used was an acrylic-type cation electrodeposition paint containing 20% solid component. A minus 10V voltage was applied to the substrate 504, and held for ten seconds to conduct electrodeposition. The solar cell was pulled up from the electrolytic bath, washed fully with pure water to wash off unreacted electrodeposition paint, placed in an oven at 50°C, and left for thirteen minutes to dry out water contents. Thereafter, the temperature of the oven was elevated at a rate of 10°C/min, and held for thirty minutes after reaching 180°C, to cure the electrodeposition resin.

Thereafter, the solar cell was taken out of the oven, and after cooling, a part of the solar cell was cut out. The observation for the surface of semiconductor layer by a scan-type electron microscope shown that semi-spherical deposits, about 5µm to 30µm in diameter, were spotted on the surface of the semiconductor layer 505. The infrared absorption spectrum analysis using an FTIR with microscopic feature on that portion confirmed that there was absorption peculiar to acrylic resin, and the electrodeposition paint was deposited. Further, the observation of OBIC image for this sample confirmed that only the deposited portion of the electrodeposition paint generated no power so that the film was deposited only on the shunt portion.

Next, the solar cell after the electrodeposition process was placed in a vapor deposition apparatus with resistance heating (not shown) in which an alloy of In and Sn was vapor deposited by resistance heating, to deposit a transparent upper electrode 107, 70nm thick having antireflection effect.

Next, the solar cell with ITI was installed on a screen printing machine, in which a grid electrodes 107, 100µm wide and 8cm long, were printed at an interval of 1cm. The conductive paste contained 70 parts of Ag filler, 30 parts of polyester binder (volume ratio), and 20 parts of ethyl acetate as the solvent. After printing, the solar cell was placed in the oven, and held at 150°C for thirty minutes to cure the conductive paste.

Further, a bus bar 108 of copper foil with an adhesive 5mm wide was bonded as shown in Fig. 1B to fabricate a single cell of 30cm square. With the same method, ten sheets of sample were fabricated.

Next, the encapsulation of these samples was conducted in the following way. EVA was laminated both on the front and back surfaces, and a fluororesin film ETFE (ethylene tetrafluoroethylene) (tradename Tefzel, manufactured by Du Pont) was further laminated on the outer surfaces thereof. Subsequently, the samples were placed in a vacuum laminator and held at 150°C for sixty minutes for the vacuum lamination, so that a solar cell module was fabricated.

The initial characteristics of the solar cell module obtained were measured. The shunt resistance was 500KΩcm² to 300KΩcm², indicating excellent characteristics, with less dispersion. Also, the solar cell characteristic was 6.2% ± 0.5%, indicating excellent characteristics and with less dispersion. The reliability test for the solar cell module was conducted in the same way as in the example 1. After completion of the test, the solar cell characteristic was 95% in average of the initial conversion efficiency, with no significant degradation. Also, the shunt resistance decreased about 10%, with no significant degradation. From these points, it could be found that a series of processings of the present invention had excellent effects.

From the results of this example, it could be found that the solar cells fabricated with the solar cell fabrication method had good yield, excellent characteristics, and high reliability.

### (5-2)

A solar cell module was fabricated in the same way as in the example 5-1, except that the electrodeposition resin used an acrylic-type anion electrodeposition resin containing 25% solid component, and a plus voltage of 10V was applied to the substrate.

The initial characteristics for obtained sample were measured. The shunt resistance was 500KΩcm² to 300KΩcm², indicating excellent characteristics, with less dispersion. Also, the solar cell characteristic was 6.5% ± 0.5% indicating excellent characteristics, with less dispersion.

The reliability test for these samples was conducted in the same way as in the example 1. The solar cell characteristic after completion of test was 95% in average of the initial conversion efficiency, with no significant degradation. Also, the shunt resistance decreased about 10%, with no significant degradation. From these points, it could be found that a series of processings of the present invention had excellent effects.

From the results of this example, it could be found that the solar cells fabricated with the solar cell fabrication method had good yield, excellent characteristics, and high reliability.

### (Example 6)

### (6-1)

A solar cell with the constitution of Fig. 2 was fabricated substantially in the same way as in the example 5.

First, a transparent upper electrode 206 of SnO₂ was deposited on a Corning 7059 substrate 201 of 30cm square, using a vapor deposition apparatus, not shown. Thereafter, upper electrode 206 was patterned by etching so that the subcells 2cm wide were arranged with a gap 5mm wide spaced. Next, using a metal mask, p-type semiconductor region 205, i-type semiconductor region 204, n-type semiconductor region 203 were deposited to substantially overlie over the upper electrode 206.

Next, in the same way as in the example 5, the forming treatment was conducted. Subsequently, the substrate 201 thus treated was immersed in an electrolytic bath 501 for the electrodeposition using an epoxy-type cation electrodeposition paint. After washing, drying and curing, the substrate was placed in a sputtering apparatus not shown to form a lower electrode of aluminum, using a metal mask, so that ten series of single cell of 30cm square were fabricated. Further, encapsulation of this sample was conducted in the same way as in the example 1. With the above fabrication method, ten sheets of solar cell module were fabricated.

The initial characteristics for obtained solar cell module were such that the conversion efficiency was 6.0% ± 1%, and the shunt resistance was from 350 to 200KΩcm².

Next, the reliability test for this sample was evaluated in the same way as in the example 1. After the temperature and humidity cycle test, the measurement for the solar cell characteristics indicated 97% of the initial value, with no degradation indicated. Also, the measurement for the shunt resistance indicated almost no change.

From the results of this example, it could be found that the solar cells fabricated with the solar cell fabrication method had good yield, excellent characteristics, and high durability.

### (6-2)

A solar cell module was fabricated in the same way as in the example 6-1, except that the electrodeposition was performed using an epoxy-type anion electrodeposition paint.

The initial characteristics for obtained solar cell module were such that the conversion efficiency was 6.3% ± 1%, and the shunt resistance was from 350 to 200KΩcm².

After the temperature and humidity cycle test, the measurement for the solar cell characteristics indicated 95% of the initial value, with no degradation indicated. Also, the measurement for the shunt resistance indicated almost no change.

From the results of this example, it could be found that the solar cells fabricated with the solar cell fabrication method had good yield, excellent characteristics, and high durability.

### (Example 7)

### (7-1)

A solar cell having a constitution as shown in Figs. 1A and 1B was fabricated substantially in the same way as in the example 5.

As in the example 1, on a substrate 101 (30cm x 30cm, 0.2mm thick) manufactured by SUS430BA was formed a lower electrode 102. The substrate 101 was taken out and placed within an RF plasma CVD film forming apparatus not shown for the deposition of n-type semiconductor region 103, i-type semiconductor region 104, and p-type semiconductor region 105 in this sequence.

Next, after the forming treatment was conducted in the exact same way as in the example 5, the back face side of the substrate 101 was covered with an insulating film made of plastic in the same way as in the example 5, and immersed in an electrolytic bath of Fig. 5. Then, the insulation treatment was made using a styrene-type cation electrodeposition paint. The substrate was washed sufficiently with pure water and had electrodeposition resin cured within an oven. Thereafter, the substrate 101 was taken out of the oven, the after cooling, ITO as a transparent upper electrode having antireflection effect was deposited 70nm thick. Further, a bus bar 108 of copper foil with adhesive was laminated thereon to fabricate a single cell of 30cm square. With the same method, ten sheets of sample were fabricated.

Further, the encapsulation of this sample was conducted in the same way as in the example 1.

The initial characteristic of the sample obtained was 6.1% ± 1%, with the series resistance being 4Ωcm², indicating excellent characteristics.

The durability characteristics for this solar cell module was evaluated in the same way as in the example 1. After completion of the temperature and humidity cycle test, the measurement for the solar cell characteristic for this sample indicated 99% of the initial value, with no degradation. The measurement for the shunt resistance indicates almost no change.

From the results of this example, it could be found that the solar cell fabricated with the solar cell fabrication method of the present invention had good yield, excellent characteristics, and high durability.

### (7-2)

A solar cell module was fabricated in the same way as in the example 7-1, except that the electrodeposition was performed using a styrene-type anion electrodeposition paint.

The initial characteristic for obtained solar cell module was 6.1% ± 1%, and the series resistance was 4Ωcm², indicating excellent characteristics.

The durability characteristic for this sample was evaluated in the same way as in the example 1. After the temperature and humidity cycle test, the measurement for the solar cell characteristics for this sample indicated 99% of the initial value, with no degradation indicated. Also, the measurement for the shunt resistance indicated almost no change.

From the results of this example, it could be found that the solar cells fabricated with the solar cell fabricaiton method of the present invention had good yield, excellent characteristics, and high durability.

### (Example 8)

### (8-1)

As in the example 5, on a substrate 101 (30cm x 30cm, 0.2 mm thick) manufactured by SUS430BA was formed a lower electrode 102. The substrate 101 was placed within an RF plasma CVD film forming apparatus not shown for the deposition of n-type semiconductor region 103, i-type semiconductor region 104, and p-type semiconductor region 105 in this sequence.

Then, the forming treatment was conducted in the exact same way as in the example 5. Then, the insulation treatment was made in the electrolytic bath of Fig. 5, using a fluorine-type cation electrodeposition paint. The substrate was washed sufficiently with pure water and cured by heating at 160°C in an oven for forty minutes. Thereafter, the substrate 101 was taken out of the oven, and after cooling, ITO as a transparent conductive layer having antireflection feature was deposited 70nm thick. Further, a bus bar 108 of copper foil with adhesive was laminated thereon to fabricate a single cell of 30cm square. In the same way, ten sheets of sample were fabricated.

Further, encapsulation of this sample was conducted in the same way as in the example 1.

The initial characteristics of the solar cell module obtained were such that the conversion efficiency was 6.8% ± 1%, with the series resistance being 4Ωcm², indicating excellent characteristics.

After completion of the temperature and humidity cycle test, the solar cell characteristic for the sample was 97% of the initial value, with no degradation. The measurement for the shunt resistance indsicates almost no change.

From the results of this example, it could be found that the solar cell fabricated with the solar cell fabrication method of the present invention had good yield, excellent characteristics, and high durability.

### (8-2)

A solar cell module was fabricated in the same way as in the example 8-1, except that the electrodeposition was performed using a fluorine-type anion electrodeposition paint.

The initial characteristics for obtained solar cell module were such that the conversion efficiency was 6.5% ± 1%, and the series resistance was 4Ωcm², indicating excellent characteristics.

After the temperature and humidity cycle test, the measurement for the solar cell characteristic for the sample indicated 96% of the initial value, with no degradation indicated. Also, the measurement for the shunt resistance indicated almost no change.

From the results of this example, it could be found that the solar cells fabricated with the solar cell fabrication method of the present invention had good yield, excellent characteristics, and high durability.

As above described, according to the present invention, as a result that the defective portion is selectively insulated with an electrodeposition resin, it is possible to provide a solar cell having high shunt resistance, high photoelectric conversion efficiency, and high reliability. Also, it is possible to provide a fabrication method of solar cell with high yield, performance and reliability.

## Claims

1. A method for compensating defects in a semiconductor,
including the steps of forming a dielectric breakdown region (305, 404) around a low resistive defective portion (304, 403) of a semiconductor region; and
selectively electrodepositing said dielectric breakdown region (305, 404) with an anion or cation resin (307, 405) for insulation to form a region comprising a cation or anion electrodeposition region.

2. A method according to claim 1, characterized in that said semiconductor is a photovoltaic element.

3. A method according to claim 1, characterized in that said semiconductor element is a non-single crystal semiconductor.

4. A method according to claim 1, characterized in that the shunt resistance of said semiconductor element is from 1 x 10³ Ωcm² to 1 x 10⁶ Ωcm².

5. A method according to claim 1, characterized in that the dimension of said region comprising an electrodeposition resin is ten times or less than that of said defective portion.

6. A method according to claim 1, characterized in that said resin is transparent.

7. A method of claim 2 in combination with claim 4 or 5, including a transparent electric conductor (303, 406) on said semiconductor region, wherein
said region comprising a cation or anion electrodeposition resin (307, 405) is electrochemically reduced.

8. A method of claim 1 including the steps of:
forming a substrate (301, 401), a semiconductor (302, 402) on said substrate (301, 401) and a transparent electric conductor (303, 406) on said semiconductor;
further including a step of short passivation treatment for dissolving and removing the material at said dielectric breakdown region before said step of selectively electrodepositing.

9. An apparatus for carrying out the method of claim 1,
including forming treatment means for yielding dielectric breakdown around a low resistive defective portion (304, 403) of a semiconductor region; and
electrodeposition means for selectively covering for insulation said dielectric breakdown region (305, 404) with an anion or cation electrodeposition resin (307, 405).

10. An apparatus of claim 9, including
means for forming a semiconductor (302, 402) on a substrate (301, 401) and a transparent electric conductor (303, 406) on said semiconductor (302, 402);
further including means for short passivation treatment to dissolve and remove material at said dielectric breakdown region.

## Patentansprüche

1. Verfahren zum Ausgleichen von Defekten in einem Halbleiter, welches die Schritte der Ausbildung eines dielektrischen Durchschlagsbereichs (305, 404) rund um einen niederohmigen fehlerhaften Abschnitt (304, 403) eines Halbleiterbereichs, und
des selektiven elektrochemischen Beschichtens des dielektrischen Durchschlagsbereichs (305, 404) mit einem Anionen- oder Kationenharz (307, 405) zur Isolierung beinhaltet, um einen Bereich auszubilden, der einen Bereich mit elektrochemischer Kationen- oder Anionenbeschichtung aufweist.

2. Verfahren gemäß Anspruch 1, dadurch gekennzeichnet, daß der Halbleiter ein fotovoltaisches Element ist.

3. Verfahren gemäß Anspruch 1, dadurch gekennzeichnet, daß das Halbleiterelement ein Nicht-Einkristall-Halbleiter ist.

4. Verfahren gemäß Anspruch 1, dadurch gekennzeichnet, daß der Nebenschlußwiderstand des Halbleiterelements von 1 × 10³ Ωcm² bis 1 × 10⁶ Ωcm² beträgt.

5. Verfahren gemäß Anspruch 1, dadurch gekennzeichnet, daß die Ausdehnung des Bereichs, der ein Harz zur elektrochemischen Beschichtung aufweist, das Zehnfache oder weniger als die des fehlerhaften Abschnitts beträgt.

6. Verfahren gemäß Anspruch 1, dadurch gekennzeichnet, daß das Harz transparent ist.

7. Verfahren gemäß Anspruch 2 in Kombination mit Anspruch 4 oder 5, das einen transparenten elektrischen Leiter (303, 406) auf dem Halbleiterbereich enthält, wobei der Bereich, der ein Kationen- oder Anionenharz (307, 405) zur elektrochemischen Beschichtung aufweist, elektrochemisch reduziert ist. .

8. Verfahren gemäß Anspruch 1, welches die Schritte aufweist,
Ausbildung eines Substrats (301, 401), eines Halbleiters (302, 402) auf dem Substrat (301, 401) und eines transparenten elektrischen Leiter (303, 406) auf dem Halbleiter, das ferner einen Schritt einer Kurzschluß-Passivierungsbehandlung aufweist, um das Material des dielektrischen Durchschlagsbereichs vor dem Schritt der selektiven elektrochemischen Beschichtung zu lösen und zu entfernen.

9. Vorrichtung zur Ausführung des Verfahrens gemäß Anspruch 1 einschließlich einer Formungs-Behandlungseinrichtung zum Hervorbringen eines dielektrischen Durchschlags rund um einen niederohmigen fehlerhaften Abschnitt (304, 403) eines Halbleiterbereichs, und einer Einrichtung zur elektrochemischen Beschichtung, um den dielektrischen Durchschlagbereich (305, 404) auf selektive Weise zur Isolierung mit einem Anionen- oder Kationenharz (307, 405) zur elektrochemischen Beschichtung abzudecken.

10. Vorrichtung gemäß Anspruch 9 einschließlich einer Einrichtung zur Ausbildung eines Halbleiters (302, 402) auf einem Substrat (301, 401) und eines transparenten elektrischen Leiters (303, 406) auf dem Halbleiter (302, 402),
die ferner eine Einrichtung für eine Kurzschluß-Passivierungsbehandlung enthält, um Material in dem dielektrischen Durchschlagsbereich zu lösen und zu entfernen.

## Revendications

1. Procédé de compensation de défauts dans un semiconducteur, comportant les étapes de formation d'une région de coupure diélectrique (305, 404) autour d'une partie défectueuse (304, 403) faiblement résistive d'une région semiconductrice; et
l'électrodéposition sélective de ladite région de coupure diélectrique (305, 404) avec une résine anionique ou cationique (307, 405), en vue d'une isolation, afin de former une région comprenant une région d'électrodéposition de cation ou d'anion.

2. Procédé selon la revendication 1, caractérisé en ce que le semiconducteur est un élément photovoltaïque.

3. Procédé selon la revendication 1, caractérisé en ce que ledit élément semiconducteur est un semiconducteur non-monocristallin.

4. Procédé selon la revendication 1, caractérisé en ce que la résistance en parallèle dudit élément semiconducteur est comprise entre 1 x 10³ Ωcm² et 1 x 10⁶ Ωcm².

5. Procédé selon la revendication 1, caractérisé en ce que la dimension de ladite région comprenant une résine d'électrodéposition est dix fois ou moins celle de ladite partie défectueuse.

6. Procédé selon la revendication 1, caractérisé en ce que ladite résine est transparente.

7. Procédé selon la revendication 2 en combinaison avec la revendication 4 ou 5, comportant un conducteur électrique transparent (303, 406) sur ladite région semiconductrice,
ladite région comprenant une résine d'électrodéposition cationique ou anionique (307, 405) étant réduite de manière électrochimique.

8. Procédé selon la revendication 1, comportant les étapes suivantes:
formation d'un substrat (301, 401), d'un semiconducteur (302, 402) sur ledit substrat (301, 401) et d'un conducteur électrique transparent (303, 406) sur ledit semiconducteur;
comportant en outre une étape de traitement de passivation court pour dissoudre et éliminer le matériau au niveau de ladite région de coupure diélectrique, avant ladite étape d'électrodéposition sélective.

9. Appareil pour la mise en oeuvre du procédé de la revendication 1, comportant un moyen de traitement de formage pour conduire à une coupure diélectrique autour d'une partie défectueuse (304, 403) faiblement résistive d'une région semiconductrice; et
un moyen d'électrodéposition pour recouvrir sélectivement, en vue de l'isolation, ladite région de coupure diélectrique (305, 404) avec une résine d'électrodéposition anionique ou cationique (307, 405).

10. Appareil selon la revendication 9, comportant
un moyen pour la formation d'un semiconducteur (302, 402) sur un substrat (301, 401) et d'un conducteur électrique transparent (303, 406) sur ledit semiconducteur (302, 402);
comportant en outre un moyen pour un traitement de passivation court en vue de dissoudre et d'éliminer le matériau au niveau de ladite région de coupure diélectrique.
